Europäisches Patentamt

(19) European Patent Office

Office européen des brevets

(11) Veröffentlichungsnummer: **0 036 595**
**B1**

(12) # EUROPÄISCHE PATENTSCHRIFT

(45) Veröffentlichungstag der Patentschrift:
18.04.84

(21) Anmeldenummer: 81101920.7

(22) Anmeldetag: 16.03.81

(51) Int. Cl.³: **G 03 F 7/12, B 41 C 1/14,**
**B 41 D 1/10**

(54) **Verfahren zur Herstellung von Siebdruckschablonen auf galvanischem Wege.**

(30) Priorität: **22.03.80 DE 3011192**

(43) Veröffentlichungstag der Anmeldung:
**30.09.81 Patentblatt 81/39**

(45) Bekanntmachung des Hinweises auf die Patenterteilung:
**18.04.84 Patentblatt 84/16**

(84) Benannte Vertragsstaaten:
**AT BE CH DE FR GB IT LI NL SE**

(56) Entgegenhaltungen:
**DE - A - 2 259 182**

(73) Patentinhaber: **HOECHST AKTIENGESELLSCHAFT,
Postfach 80 03 20, D-6230 Frankfurt am Main 80 (DE)**

(72) Erfinder: **Steppan, Hartmut, Dr., Panoramastrasse 17,
D-6200 Wiesbaden-Dotzheim (DE)**
Erfinder: **Wildenhain, Barbara, geb.Grundmeyer,
Rhönstrasse 9, D-6229 Walluf 1 (DE)**
Erfinder: **Ruckert, Hans, Dr., Erbsenacker 21,
D-6200 Wiesbaden-Naurod (DE)**

Verfahren zur Herstellung von Siebdruckschablonen auf galvanischem Wege

Die Erfindung betrifft ein Verfahren zur Herstellung von dessinierten Siebdruckschablonen auf galvanischem Wege.

Die galvanoplastische Herstellung von Sieben, auch für die Herstellung von Druckschablonen, ist in verschiedenen Variationen möglich und z.B. in dem Artikel „Galvanoplastische Siebherstellung" in Metalloberfläche 19 (1965), 369-372, beschrieben.

Man geht zur Herstellung von gerasterten Schablonen allgemein von einer metallischen Matrize als Träger für die galvanisch abzuscheidende Metallschablone aus. Ist die Matrize gleichförmig mit einem Raster aus Punkten aus elektrisch nichtleitendem Material, z.B. Kunststoff, versehen, das mittels Photoresist- oder Siebdruckverfahren aufgebracht worden ist, so erhält man durch Galvanisieren und Abziehen der dabei entstandenen Metallschicht von der ggf. mit einer Trennschicht versehenen Matrize eine Schablone mit Löchern der Anordnung und ungefähren Grösse der Rasterpunkte auf der Matrize. Das Raster verläuft bei zylinderförmigen Rundschablonen nahtlos um die Zylinderoberfläche herum.

Die Dessinierung derartiger Siebe kann entweder durch Aufbringen einer Photoresistschablone oder einer Metallschablone erfolgen.

Das erste Verfahren, das z.B. in der DE-AS Nr. 2214728 oder der DE-OS Nr. 2542430 beschrieben ist, führt naturgemäss zu Siebdruckschablonen mit geringerer Druckauflage als rein metallische Schablonen. Man hat versucht, diesem Nachteil dadurch zu begegnen, dass man auf der Metallunterlage und der leitfähig gemachten Photoresistschablone stromlos eine dünne Metallschicht abscheider (DE-OS Nr. 2324372). Damit ist jedoch nicht die Haltbarkeit einer rein metallischen Schablone zu erreichen. Das zweite Verfahren, das z.B. in der DE-OS Nr. 2539845 beschrieben ist, erfordert das Aufbringen einer zusätzlichen Metallschicht, an deren Haftung auf dem Metallsieb hohe Anforderungen gestellt werden müssen, damit nicht im Verlauf des Druckvorgangs einzelne Elemente aus der Metallschablone von dem Sieb abgelöst werden. Auch ist die mechanische Beanspruchbarkeit derartiger Schablonen bei der Rakelreibung durch die zumeist relativ dünne bildmässige Metallschablone begrenzt.

Dessinierte Siebdruckschablonen, die in einer Stufe galvanisch erzeugt werden können, sind deshalb vorzuziehen.

Ein derartiges Verfahren, bei dem von einer bildmässig gerasterten Vorlage eine Kopie auf einer Photoresistschicht hergestellt und die entwickelte Photoresistschicht unmittelbar als Schablone für die Metallabscheidung dient, ist in der DE-AS Nr. 2640268 beschrieben. Wenn nach diesem Verfahren Rundschablonen hergestellt werden sollen, ist es im allgemeinen nicht möglich, das Rastermuster ohne Nachtstelle, die den Enden der Vorlage entspricht, auf den Zylinder zu übertragen. Obwohl dieses Verfahren eine genaue Wiedergabe der Grösse der Rasterpunkte durch entsprechend unterschiedliche Weite der Rasteröffnungen ermöglicht, werden beim Drucken von Siebdruckschablonen mit derartigen flächenvariablen Rastern im allgemeinen keine vorlagengetreuen Farbdichten erhalten, da die engeren Öffnungen dem Druchtritt der Druckfarbe überproportional im Vergleich zu weiteren Öffnungen Widerstand entgegensetzen.

Ein Verfahren zur Herstellung von Siebdruckschablonen, die aus einer Überlagerung eines Bildmusters mit einem Sieb mit Öffnungen gleichen Durchmessers bestehen, durch Galvanisieren in einer Stufe ist in der DE-AS Nr. 2051728, Spalten 1 und 2, als Stand der Technik beschrieben. Dabei wird eine zylindrische Matrize aus Metall, die ein vertieftes, mit elektrisch isolierendem Material ausgefülltes Raster aufweist, mit einer lichtempfindlichen Negativschicht überzogen, die durch Belichten leitfähig wird oder gemacht werden kann, und die Schicht belichtet und entwickelt. Auf der so erhaltenen dessinierten Matrize wird galvanisch Metall sowohl an den leitfähig gemachten Bildstellen der Photoresistschicht als auch an den die isolierenden Rasterpunkte der Matrize umgebenden Metallstegen abgeschieden. Die erhaltene dessinierte Siebdruckschablone wird dann von der Matrize abgenommen. Als Nachteil dieses Verfahrens wird in der Druckschrift angegeben, dass mit der Dicke der galvanoplastisch erzeugten Schablone die Öffnungen über den Kunststoffrasterpunkten allmählich zuwachsen, d.h. der Radius der Öffnungen nimmt um einen Betrag ab, der grössenordnungsmässig der Schichtdicke entspricht. Zur Behebung dieses Nachteils wird in der Druckschrift ein Verfahren empfohlen, bei dem über der zu galvanisierenden mit dem Photoresist bedeckten Matrize Drahtwindungen mit Abstand nebeneinander angebracht und während der Galvanisierung in das abgeschiedene Metall eingebettet werden, das dann nur eine geringere Schichtdicke zu haben braucht. Dieses Verfahren erfordert ein sehr präzises Anbringen der Drahtwindungen und hat sich in der Praxis nicht durchgesetzt. Es hat sich vielmehr als praktikabler erwiesen, die gewünschte Lochgrösse dadurch zu erreichen, dass man die isolierenden Rasterpunkte auf der Matrize um einen entsprechenden Betrag grösser wählt, was bei Rasterpunkten gleichbleibender Grösse ohne weiteres möglich ist.

Ein anderer Nachteil dieses Verfahrens ist jedoch darin zu erblicken, dass die Photoresistschicht in ausreichender Menge Zusätze enthalten muss, die durch Belichtung leitfähig werden, wie es z.B. in der DE-AS Nr. 1771876 beschrieben ist. Die dort beschriebene Photoresistschicht enthält eine grosse Menge in Wasser wenig löslicher Metallsalze, die während der Belichtung zum Metall reduziert werden. Die Metallsalze, z.B. des Silbers, Kupfers, oder Zinks, erhöhen die Kosten des lichtempfindlichen Gemischs und können im übrigen dessen sonstige Eigenschaften, insbesondere die Lichtempfindlichkeit und die Resistenz der lichtgehärteten Schicht gegenüber den meist stark aggressiven Galvanobädern, beeinträchtigen. Im übrigen ist, soweit die Reduktion zum Metall eine Wirkung der Belichtung ist, eine verhältnismässig intensive und lange Belichtung erforderlich, um an der Oberfläche eine für die Galvanisierung ausreichende elektrische Leitfähigkeit zu erzeugen.

Aufgabe der Erfindung war es, ein Verfahren zur galvanischen Herstellung von Siebdruckschablonen der zuletzt geschilderten Art vorzuschlagen, bei dem die Photoresistschicht in ihrer Masse keine Zusätze zum Leitfähigmachen enthält, das einfacher und sicherer und vorzugsweise mit billigeren Materialen durchgeführt werden kann.

Die Erfindung geht aus von einem Verfahren zur Herstellung von Siebdruckschablonen auf galvanischem Wege, bei dem eine metallische, rasterförmig mit Punkten aus isolierendem Material versehene Matrize mit einer Photoresistschicht überzogen, die Photoresistschicht bildmässig belichtet und durch Auswaschen entwickelt wird, wobei die stehengebliebenen Bereiche der Photoresistschicht im Verlauf der Bebilderung elektrisch leitfähig gemacht werden, auf der leitfähigen Bildschablone sowie auf den die isolierenden Rasterpunkte umgebenden Stegen der Matrize galvanisch Metall bis zur gewünschten Höhe abgeschieden und die so erhaltene dessinierte Siebdruckschablone von der Matrize abgenommen wird.

Das erfindungsgemässe Verfahren ist dadurch gekennzeichnet, dass man die Photoresistschicht nur an ihrer Oberfläche und vor dem Entwickeln leitfähig macht.

Das Leitfähigmachen der Oberfläche kann in an sich bekannter Weise durch Erzeugung von Edelmetallkeimen und ggf. stromlose Metallabscheidung an diesen Keimen erfolgen, ähnlich wie es in der DE-OS Nr. 2324372 beschrieben ist. Es kann durch Bedampfen mit dünnen Schichten leitfähiger Stoffe, z.B. von Metallen, oder durch mechanisches Aufbringen leitfähiger Partikeln, z.B. durch Einreiben mit Pulvern oder Pasten, durchgeführt werden.

Wenn der leitfähige Stoff Licht im aktinischen Bereich der Photoresistschicht absorbiert, ist es zweckmässig, die Oberfläche erst nach der Belichtung der Photoresistschicht leitfähig zu machen.

Als besonders einfach und wirksam im Rahmen des erfindungsgemässen Verfahrens hat sich das Aufbringen einer Schicht von leitfähigen Partikeln, entweder in Form einer Dispersion oder — bevorzugt — als trockenes Pulver, bewährt.

Als leitfähige Partikel sind z.B. Metallpulver, leitfähige Metallverbindungen, Russ und Graphit geeignet. Graphit wird dabei besonders bevorzugt. Die Partikeln können in Form eines trockenen, feinteiligen Pulvers mechanisch, zweckmässig durch Reiben mit einem geeigneten Material, z.B. einem Tampon oder Plüsch, zu einer gleichmässigen, zusammenhängenden, fest haftenden Schicht auf die Oberfläche der Photoresistschicht aufgebracht werden. Sie können auch in Form einer Dispersion in einem Lösungsmittel, ggf. unter Zusatz kleinerer Mengen organischer Bindemittel oder Netzmittel, aufgebracht und dort verrieben werden.

Das Leitfähigmachen der Oberfläche von Photoresistschichten durch Aufbringen von Graphit zwecks späterer galvanischer Metallabscheidung ist an sich aus der DE-OS Nr. 1772590, Beispiel 26, bekannt. Dort wird allerdings das Einreiben mit Graphit primär dazu verwendet, ein latentes Bild sichtbar zu machen. Der Graphit, der zusammen mit Kerosin auf die Oberfläche einwirkt, wird vorwiegend an den unbelichteten Oberflächenbereichen festgehalten und ergibt ein sichtbares Bild. Ein Auswaschen der Nichtbildstellen der Schicht erfolgt nicht. Es ist ersichtlich, dass die durch Belichten gehärteten Bereiche dort wenig oder gar keinen Graphit annehmen. Es ist deshalb überraschend, dass bei dem erfindungsgemässen Verfahren durch intensives Einreiben gerade die weniger löslichen Photoresistschichtbereiche den Graphit so gut annehmen, dass auch nach dem Auswaschen der stärker löslichen Bereiche mit einem Entwickler noch eine so dichte, leitfähige Schicht zurückbleibt, dass darauf galvanisch eine zusammenhängende, fehlstellenfreie Metallschicht abgeschieden werden kann.

Als metallische Matrizen werden bei dem erfindungsgemässen Verfahren entweder glatte Folien, vorzugsweise aus Nickel, verwendet, auf die erhabene nichtleitende Punkte, vorteilhaft aus Kunstoff, rasterförmig verteils aufgebracht worden sind. Das Aufbringen kann im Siebdruck- oder Photoresistverfahren erfolgen. Die Matrize kann auch mit rasterförmig verteilten Vertiefungen oder Perforationen versehen sein, die bis zur Oberfläche der Matrize mit nichtleitendem Kunststoff ausgefüllt sind. Diese Ausführungsform ist besonders für die Herstellung nahtloser Rundschablonen geeignet, wenn sie in Zylinderform vorliegt, wie es in der DE-AS Nr. 2051728, Spalte 1, beschrieben ist.

Auf die Matrize wird in üblicher Weise eine Photoresistschicht aufgebracht, die durch Belichten und Entwickeln mit einer geeigneten Entwicklerflüssigkeit zum reliefartigen Bild verarbeitet werden kann. Es sind sowohl lichthärtbare, negativ arbeitende als auch durch Licht löslich werdende, also positiv arbeitende Resists geeignet, wobei die letzteren bevorzugt werden.

Geeignete, negativ arbeitende Photoresistmaterialien sind solche aus photopolymerisierbaren Gemischen von polymerisierbaren, äthylenisch ungesättigten Verbindungen, polymeren Bindemitteln und Photoinitiatoren, aus lichtvernetzbaren Verbindungen, wie Polyvinylcinamat, oder aus negativ arbeitenden Diazo- oder Azidoverbindungen, ggf. im Gemisch mit Bindemitteln.

Geeignete, positiv arbeitende lichtempfindliche Gemische sind solche aus o-Chinondiaziden und alkalilöslichen Harzen, insbesondere Phenolharzen, oder aus säurespaltbaren Verbindungen, wie Orthocarbonsäureestern oder Acetalen, und Verbindungen, die photolytisch Säure bilden, ggf. im Gemisch mit alkalilöslichen Harzen, besonders Phenolharzen.

Die Photoresistschichten können in bekannter Weise entweder durch Beschichten aus einer Lösung oder durch Laminieren einer vorgefertigten festen Schicht unter Druck und Erwärmen aufgebracht werden.

Bevorzugt werden lichtempfindliche Photoresistschichten, sie sich mit verdünnten, wässerig-alkalischen Lösungen entwickeln lassen.

Die Photoresistschicht wird in üblicher Weise unter einer Vorlage der Bildschablone belichtet. Wie bereits erwähnt, kann die Schicht vor oder nach dem Belichten mit der leitfähigen Oberfläche versehen werden. Da die leitfähigen Substanzen gewöhnlich Licht in dem Spektralbereich absorbieren, in dem die Photoresistschicht lichtempfindlich ist, wird die leitfähige Substanz bevorzugt nach der Bildbelichtung aufgebracht. Obwohl eine besonders starke Annahme von leitfähiger Substanz gerade an den Schichtbereichen zu erwarten war, die durch die Entwicklung entfernt werden, lassen sich diese Bereiche zusammen mit der leitfähigen Deckschicht problemlos entfernen, insbesondere bei Verwendung der bevorzugten, wässerig-alkalischen Entwicklerlösungen. Dagegen bleibt die leitfähige Schicht auf den zurückbleibenden Schichtbereichen jedenfalls in so ausreichendem Masse zurück, dass sie eine fest haftende, dichte fehlerlose leitfähige Oberfläche bildet. Ein eventuell vorhandener Überschuss an leitfähiger Substanz kann dabei abgeschwemmt werden.

Man erhält somit eine bildmässig modifizierte Matrize, die aus der leitfähigen Photoresistschablone und den leitfähigen, durch Entwickeln freigelegten Metallstegen der Metallmatrize, die die nichtleitenden Kunststoffrasterpunkte umgeben, sowie aus diesen nichtleitenden Rasterelementen besteht.

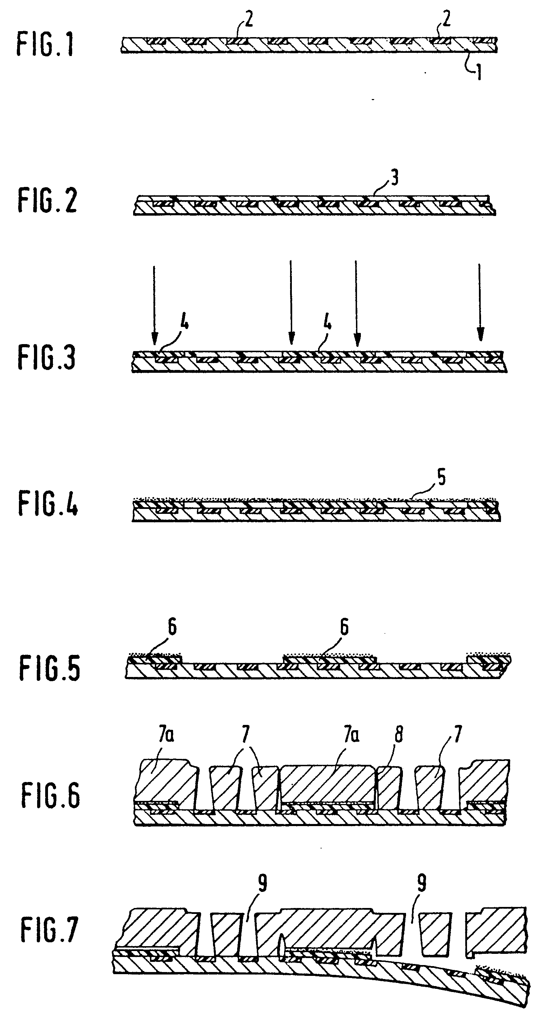

Diese Matrize wird anschliessend galvanisiert, vorzugsweise galvanisch vernickelt. Die Galvanisierung beginnt an der freigelegten Metalloberfläche der Matrize und auf der leitfähigen Resistschicht, wobei das Metall an deren Rändern mit den benachbarten Siebstegen zusammenwächst. Je nach gewünschter Schablonendicke kann das Zuwachsen an den mit Kunststoffrasterpunkten abgedeckten Stellen durch entsprechende Wahl von Grösse, Form und Abstand dieser Punkte kompensiert werden. Diese Ausführungsform wird durch die Fig. 1 bis 7 erläutert.

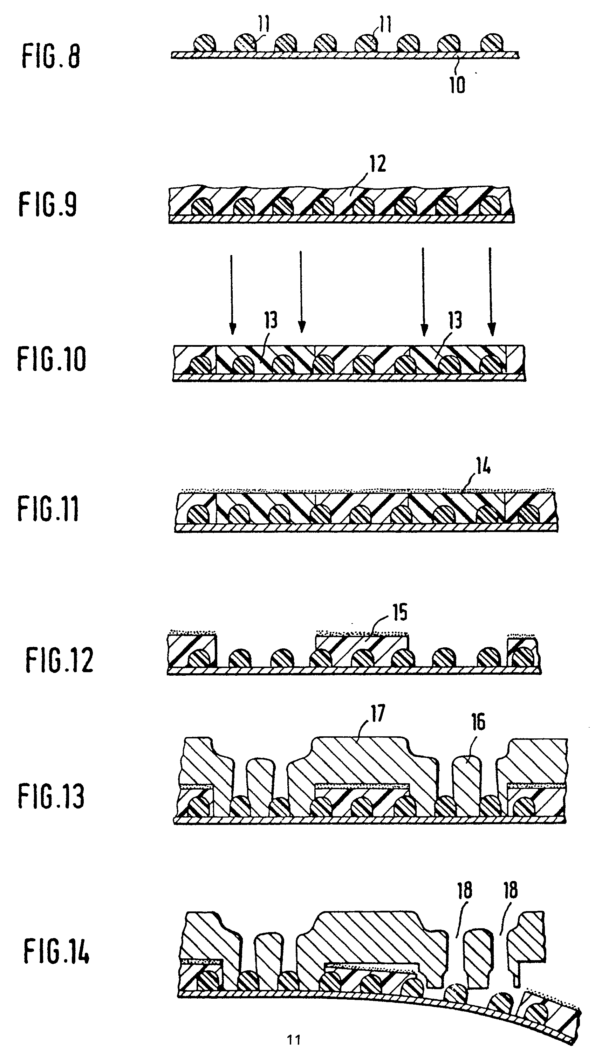

Bei der obenerwähnten anderen Ausgestaltung des Verfahrens wird von elastischen Flach- oder Rundmatrizen mit glatter Oberfläche ausgegangen, auf die in rasterförmiger Anordnung erhabene nichtleitende Punkte bzw. Flecken aus Kunststoff aufgebracht sind. Als Kunststoff wird zweckmässig ein zähes, in der Wärme nicht verformbares Material, z.B. ein gehärtetes Epoxyharz verwendet. Für die Herstellung von Flachschablonen werden bevorzugt dickere vorgefertigte Resistschichten unter Druck und Erwärmen auf die Matrize laminiert und gleichmässig zwischen den Punkten verteilt. Bei dieser Arbeitsweise wird das Zuwachsen der Löcher in der Schablone weitgehend dadurch vermindert, dass ein Zuwachsen erst oberhalb des Niveaus der Rasterpunkte beginnen kann. Diese Ausführungsform wird durch die Fig. 8 bis 14 erläutert.

Die Fig. 1 bis 7 erläutern die Herstellung einer Siebdruckschablone nach der zuerst angegebenen Ausführungsform des erfindungsgemässen Verfahrens.

Fig. 1 zeigt eine Nickelmatrize 1 mit rasterartig angeordneten, mit nichtleitendem Kunstoff 2 ausgefüllten Vertiefungen.

Fig. 2 zeigt die Matrize gemäss Fig. 1, die mit einer negativ arbeitenden Photoresistschicht 3 überzogen ist.

Fig. 3 zeigt die gleiche Matrize, die an den Stellen 4 der Photoresistschicht bildmässig belichtet wird.

Fig. 4 zeigt die belichtete und mit einem leitfähigen Pulver 5 bedeckte Matrize.

Fig. 5 zeigt die gleiche Matrize nach dem Entwickeln, wonach die lichtgehärtete, mit der Pulverschicht bedeckte Photoresistschablone 6 zurückbleibt.

Fig. 6 zeigt die Matrize nach der galvanischen Abscheidung von Metall auf ihren leitfähigen Oberflächenbereichen. Dabei werden in den nicht von der Photoresistschablone abdeckten Bildbereichen Metallstege 7 gebildet, die die nichtleitenden Rasterpunkte 2 umgeben. Es werden ferner bildmässig angeordnete Schablonenelemente 7a über der Photoresistschablone gebildet. Metallstege 7, die in unmittelbarer Nähe von Schablonenelementen 7a liegen, wachsen an den Kontaktstellen 8 mit diesen zusammen.

Fig. 7 zeigt die fertige Siebdruckschablone mit bereits teilweise abgezogener Matrize. Durch die bildmässig verteilten Öffnungen 9 wird beim Gebrauch der Schablone Druckfarbe gedrückt.

Eine andere Ausführungsform des Verfahrens wird in den Fig. 8 bis 14 dargestellt.

Fig. 8 zeigt eine Nickelmatrize 10 mit glatter Oberfläche, auf der rastermässig Punkte aus nichtleitendem Kunststoff 11 angeordnet sind.

Fig. 9 zeigt die mit einer positiv arbeitenden Trockenresistschicht 12 unter Druck und Erwärmen kaschierte Matrize.

Fig. 10 zeigt die gleiche Matrize nach dem Belichten an den Bildstellen 13.

Fig. 11 zeigt die belichtete und mit einer leitfähigen Pulverschicht 14 überzogene Matrize.

Fig. 12 zeigt die Matrize nach dem Entwickeln, wobei die nicht belichteten, mit der leitfähigen Pulverschicht bedeckten Schablonenbereiche 15 der Photoresistschicht zurückbleiben.

Fig. 13 zeigt die Matrize nach der galvanischen Abscheidung von Metall. Es sind wiederum Metallstege 16 in den Bildbereichen und Schablonenelemente 17 entstanden, die an ihren Kanten mit benachbarten Stegen 16 zusammengewachsen sind.

Fig. 14 zeigt die fertige Metallschablone, von der die Matrize teilweise abgezogen ist. Die Öffnungen 18 entsprechen den Bildelementen beim Druck.

Die folgenden Beispiele erläutern bevorzugte Ausführungsformen des erfindungsgemässen Verfahrens. Mengenverhältnisse und Prozente sind, wenn nichts anderes angegeben ist, in Gewichtseinheiten zu verstehen. Gewichtsteile (Gt) und Volumenteile (Vt) stehen zueinander im Verhältnis von Gramm zu Kubikzentimeter.

*Beispiel 1:*

Zur Herstellung einer Rotationsnickelschablone wurde von einer durch Behandeln mit verdünnter Chromsäure mit einer leitfähigen Trennschicht versehenen zylindrischen Nickelmatrize 1 ausgegangen, die rasterförmig mit Vertiefungen versehen war, die mit einem nicht leitfähigen, in Äthanol unlöslichen Epoxyharz 2 gefüllt waren. Darauf wurde eine Lösung von

1 Gt 4,4'-Diazidostilben-2,2'-disulfonsäure, und

2 Gt eines Polyamids aus Hexamethylendiamin und Adipinsäure in

90 Gt Äthanol, und

10 Gt Wasser

mittels einer Sprühpistole, die an einer Spindel am rotierenden Zylinder entlangläuft, gleichmässig ca. 2 µm dick aufgebracht. Nach dem Trocknen der Negativphotoresistschicht 3 wurde unter einer positiven Vorlage des zu druckenden Motivs belichtet. Die belichtete Oberfläche wurde mit feinpulvrigem Molybdänsulfid, chemisch rein, wie es als technisches Schmiermittel verwendet wird, eingepudert und nahm dieses als dichten, fest haftenden Überzug 5 an. Beim Entwickeln der Schicht mit Äthanol blieb der leitfähige Überzug an den belichteten Stellen 4 dicht und lückenlos haften, an den unbelichteten Bildpartien wurde er mit der Schicht entfernt.

Anschliessend wurde sowohl über der leitfähig gemachten Photoresistschablone 6 als auch über den freigelegten Metallstegen der Matrize 1 galvanisch Nickel abgeschieden, bis die gewünschte Wandstärke für eine solche Rotationsschablone erreicht war. Über den rasterförmig verteilten Epoxyharzflecken 2 in der Matrizenoberfläche wurde kein Metall aufgebaut. So entstanden in den Bildpartien der Galvanoschablone die Löcher 9, durch die später die Siebdruckfarbe gedruckt wurde.

Die dessinierte Schablone wurde von der Nikkelmatrize abgezogen und mit organischem Lösungsmittel gewaschen, um sie von anhaftenden Photoresist- und Molybdänsulfidresten zu reinigen.

*Beispiel 2:*

Für die Herstellung einer metallischen Siebdruckflachschablone wurde ausgegangen von einer Nickelfolie 10, auf die in Siebdruckdickfilmtechnik Rasterpunkte 11 von ca. 40 µm Durchmesser und 30 µm Höhe aus alkaliunlöslichem, nicht leitfähigem gehärtetem Epoxyharz aufgetragen worden waren. Darauf wurde unter Druck und Wärme eine erweichende Positivtrockenresistschicht 12 von ca. 38 µm Dicke kaschiert. Die Schicht bestand aus 75% Kresolformaldehydnovolak (Schmelzbereich 105-120°C), 20% 2,4-Bis-(diphenoxymethoxy)benzoesäuremethylester und 5% Naphthochinon-(1,2)-diazid-(2)-4-sulfonsäurechlorid und war auf eine Trägerfolie aus Polyäthylenterephthalat aufgebracht. Die thermoplastische lichtempfindliche Schicht 12 verlief dabei und umhüllte die Rasterpunkte. Nach dem Abkühlen wurde die Trägerfolie von der weitgehens nivellierten Resistoberfläche abgezogen; diese wurde etwas nachgetrocknet und unter einem Strichnegativ des zu druckenden Motivs belichtet.

Anschliessend wurde ein pulverförmiger leitfähiger Furnaceruss mit 1% flüchtigen Bestandteilen und einer Struktur (Dibutylphthalatadsorption) von 119 ccm/100 g aufgetragen, mechanisch gleichmässig verteilt und der Überschuss abgeblasen oder abgesaugt. Nach dem Entwickeln der mit der Russschicht 14 bedeckten Photoresistschicht wurde ein Relief aus bepuderter Resistschicht 15 und erhabenen Kunststofffrasterpunkten 11 auf der Nickelfolie 10 erhalten. Darauf wurde galvanisch eine ca. 60 µm starke Nickelschicht abgeschieden. Die Nickelschicht setzte sich aus stegförmigen Anteilen 16 im Bereich der Bildstellen, die unmittelbar von der Oberfläche der Nickelmatrize ausgingen, und Schablonenteilen 17 im Bereich der Nichtbildstellen zusammen, die von der leitfähig gemachten Resistoberfläche 15 ausgingen. Im Bereich der Resistkanten wuchsen die Anteile 16 und 17 zu gemeinsamen Reliefelementen zusammen. Wegen der relativ grossen Höhe der nichtleitenden Kunststofffrasterpunkte beginnt das galvanische Zuwachsen der Löcher 18 vergleichsweise erst später als im Falle plan geschliffener, mit Kunststoff gefüllter Vertiefungen oder Perforationslöcher in der Nickelmatrize.

Statt mit dem Russpulver kann auch mit einer Paste leitfähig gemacht werden. Dazu wurde handelsüblicher elektrophotographischer Toner mit etwas Netzmittel und Benzin zu einem nach Belieben zu verdünnenden Teig angerührt und auf die belichtete Kopierschicht gestrichen, wo dieser sehr schnell antrocknete. Als Toner wurde ein Gemisch aus 85 Gew.-% eines Styrol/butylmethacrylat-Mischpolymerisats (80:20) und 15% leitfähigem Russ und als Netzmittel ein Reaktionsprodukt aus Nonylphenol und Äthylenoxid verwendet.

*Beispiel 3:*

Eine Nickelmatrize mit 24 sechseckigen Löchern pro Zentimeter, die glatt mit einem nicht leitfähigen gehärteten Epoxyharz ausgefüllt waren, wurde mit einem Positivkopierlack der folgenden Zusammensetzung:

24 Gt Novolak wie in Beispiel 2

4 Gt des Veresterungsprodukts aus 1,2-Naphthochinon-2-diazid-5-sulfonsäurechlorid und 2,3,4-Trihydroxybenzophenon, und

0,1 Gt Kristallviolett in

50,3 Gt 1,1,1-Trichloräthan

14,4 Gt Isopropanol, und

7,2 Gt Butylacetat

beschichtet und zu einer ca. 2 bis 6 µm dicken

Schicht getrocknet. Anschliessend wurde unter einer negativen Strichvorlage des gewünschten Motivs ausreichend belichtet und dann mit einem mit feinpulvrigem Graphit belegten Tampon oder Plüsch gleichmässig über belichtete Oberfläche so gewischt, dass eine gleichmässige, dichte Bepuderung erfolgte. Die oberflächlich leitfähig gemachte Kopierschicht wurde an den belichteten Flächenpartien mit einem Entwickler aus

     5,5% Natriummetasilikat · 9 $H_2O$
     3,4% Trinatriumphosphat · 12 $H_2O$
     0,4% Monoatriumphosphat (wasserfrei), und
     90,7% Wasser

entfernt, mit Wasser gespült und getrocknet. Die Graphitschicht behinderte die Entwicklung nicht, sie blieb aber an den nicht belichteten und nicht entwickelten Stellen dicht haften.

Schliesslich wurde in einem handelsüblichen Ni/Galvano-Bad, z.B. einem Ni/Sulfamat-Bad, bis zur gewünschten Dicke von ca. 0,1 mm Nickel abgeschieden. Die Abscheidung begann an den freigelegten Metallstellen der wie üblich mit einer leitfähigen Trennschicht versehenen Matrize. Die Galvanisierung setzte zugleich auch an den leitfähig gemachten Flächen ein, so dass sich an den Nichtbildstellen eine geschlossene Nickelfläche bildete. Nach Abziehen der galvanoplastisch erzeugten Schablone wurde diese von evtl. Kopierlack- und Puderresten gereinigt und zum Drucken eingerichter. Die Farbe wurde durch die bildmässig mit Löchern versehenen Flächenpartien auf den Druckträger übertragen.

*Beispiel 4:*

Auf eine gleichmässig perforierte, mit Epoxyharz gefüllte zylindrische Nickelmatrize wurde mit einer passenden Rundrakel ein Siebdrucklack folgender Zusammensetzung

     40 Gt einer 50%igen wässerigen Dispersion eines Vinylacetatmischpolymerisats
     80 Gt Polyvinylalkohol (K-Wert 26, 12% Restacetylgruppen)
     3 Gt eines Kondensationsprodukts aus 3-Methoxydiphenylamin-4-diazoniumsalz und Formaldehyd, hergestellt in 85%iger Phosphorsäure, eingesetzt als Rohkondensat, und
     280 Gt Wasser

zu einer 10 μm dicken Schicht getrocknet. Nach Belichten unter einer positiven Vorlage wurde die gesamte Zylinderoberfläche mit einem 1:1-Gemisch von Graphit und Molybdänsulfid mechanisch behandelt und damit dünn und dicht bedeckt. Anschliessend wurden, wie üblich durch Anquellen und Abspritzen mit Leitungswasser, die unbelichteten, bildmässigen Schichtpartien samt darauf haftender, leitfähiger Schicht entfernt und so das Matrizenmetall und die mit Kunststoff gefüllten Rasterlöcher darin freigelegt. Durch Galvanisieren mit Nickel bis zur gewünschten Dicke und Abziehen der so entstandenen Nickelhaut wurde relativ einfach eine brauchbare Rundschablone erhalten, die für das Bedrucken von Textilien und Papier im Rotationssiebdruck geeignet war.

*Beispiel 5:*

Es wurde vorgegangen wie in Beispiel 2 und die dort angegebene Matrize mit einer 50 μm dicken Negativtrockenresistschicht der folgenden Zusammensetzung

     42,7% eines Terpolymerisats aus n-Hexylmethacrylat, Methacrylsäure und Styrol (60:30:10) mit einem mittleren Molgewicht von ca. 35 000
     36,7% eines polymerisierbaren Diurethans, das durch Umsetzung von 1 mol 2,2,4-Trimethylhexamethylendiisocyanat mit 2 mol Hydroxyäthylmethacrylat erhalten wurde
     1,3% 9-Phenylacridin
     0,6% 3-Mercaptopropionsäure-2,4-dichloranilid
     0,2% eines blauen Azofarbstoffs, erhalten durch Kuppeln von 2,4-Dinitro-6-chlorbenzoldiazoniumsalz mit 2-Methoxy-5-acetylamino-N-cyanoäthyl-N-hydroxyäthylanilin, und
     18,4% 4-Hydroxybenzoesäure-(2-äthylhexyl)ester

die sich auf einer 25 μm dicken Trägerfolie aus Polyäthylenterephthalat befand, unter Druck und Erwärmen laminiert, wobei sich die Schicht der rasterförmig strukturierten Matrizenoberfläche anlegte. Die Photopolymerschicht wurde durch die Trägerfolie hindurch unter einer positiven Vorlage belichtet und anschliessend die Trägerfolie abgezogen. Durch Bepudern mit einer 1:1-Mischung von Graphit und leitfähigem Russ mit einer spezifischen Oberfläche (BET) von 200 m²/g, einer Struktur (BDP) von 110 ccm/100 g und 2,0% flüchtigen Bestandteilen wurde ebenfalls eine gleichmässige, dichte leitfähige Oberfläche erzeugt. Sie wurde durch Besprühen mit einer 0,8%igen Sodalösung bildmässig entwickelt. Nach Spülen, Trocknen, Galvanisieren und Abziehen der Nickelhaut wurde eine brauchbare Siebdruckschablone erhalten.

**Patentansprüche**

1. Verfahren zur Herstellung von Siebdruckschablonen auf galvanischem Wege, bei dem eine metallische, rasterförmig mit Punkten aus isolierendem Material versehene Matrize mit einer Photoresistschicht überzogen, die Photoresistschicht bildmässig belichtet und durch Auswaschen entwickelt wird, wobei die stehengeblieben Bereiche der Photoresistschicht im Verlauf der Bebilderung elektrisch leitfähig gemacht werden, auf der leitfähigen Bildschablone sowie auf den die isolierenden Rasterpunkte umgebenden Stegen der Matrize Metall bis zur gewünschten Höhe galvanisch abgeschieden und die so erhaltene dessinierte Siebdruckschablone von der Matrize abgenommen wird, dadurch gekennzeichnet, dass man die Photoresistschicht nur an ihrer Oberfläche und vor dem Entwickeln leitfähig macht.

2. Verfahren nach Anspruch 1, dadurch gekennzeichnet, dass man die Oberfläche der Photoresistschicht nach dem Belichten leitfähig macht.

3. Verfahren nach Anspruch 1, dadurch gekennzeichnet, dass man die Oberfläche der Photoresistschicht durch Aufbringen von leitfähigen Partikeln leitfähig macht.

4. Verfahren nach Anspruch 3, dadurch gekennzeichnet, dass man als leitfähige Partikel Graphitpulver verwendet.

5. Verfahren nach Anspruch 1, dadurch gekennzeichnet, dass man eine durch Belichten löslich werdende Photoresistschicht verwendet.

6. Verfahren nach Anspruch 1, dadurch gekennzeichnet, dass man eine zylindrische Matrize verwendet.

7. Verfahren nach Anspruch 1, dadurch gekennzeichnet, dass man eine Matrize mit rasterförmig angeordneten Vertiefungen oder Perforationen verwendet, die mit nichtleitendem Material ausgefüllt sind.

8. Verfahren nach Anspruch 1, dadurch gekennzeichnet, dass man eine Matrize mit ebener Oberfläche verwendet, auf die Rasterpunkte aus nichtleitendem Material aufgesetzt sind.

9. Verfahren nach Anspruch 1, dadurch gekennzeichnet, dass man die Siebdruckschablone durch galvanisches Abscheiden von Nickel erzeugt.

**Claims**

1. A process for the preparation of screen-printing stencils by an electroplating method, in which a metallic matrix provided in the manner of a screen with dots of insulating material is coated with a Photoresist layer, the Photoresist layer is exposed imagewise and developed by washing out, and those areas of the Photoresist layer which have remained in place are rendered electrically conductive in the course of imaging, metal is electro-deposited up to the desired height on the conductive image stencil and on the matrix ridges surrounding the insulating screen dots, and the patterned screen printing stencil thus obtained is removed from the matrix, characterized in that the Photoresist layer is rendered conductive only on its surface and before developping.

2. A process as claimed in claim 1, wherein the surface of the Photoresist layer is rendered conductive after exposure.

3. A process as claimed in claim 1, wherein the surface of the Photoresist layer is rendered conductive by the application of conductive particles.

4. A process as claimed in claim 3, wherein graphite powder is used as the conductive particles.

5. A process as claimed in claim 1, wherein a Photoresist layer is used which becomes soluble by exposure.

6. A process as claimed in claim 1, wherein a cylindrical matrix is used.

7. A process as claimed in claim 1, wherein the matrix used has depressions or perforations which are arranged in the form of a screen and are filled with a non-conductive material.

8. A·process as claimed in claim 1, wherein the matrix used has a flat surface on which screen dots of a non-conductive material have been placed.

9. A process as claimed in claim 1, wherein the screen-printing stencil is produced by electrodeposition of nickel.

**Revendications**

1. Procédé de préparation de clichés sérigraphiques par dépôt électrolytique, dans lequel une matrice métallique, munie de points de matière isolante selon un réseau, est revêtue d'une couche de Photoresist, la couche de Photoresist est exposée à la lumière suivant une image et est développée par lavage, les régions subsistantes de la couche de Photoresist étant rendues électriquement conductrices au cours de l'exposition à la lumière, on dépose électrolytiquement du métal sur le cliché image conducteur ainsi que sur les nervures de la matrice entourant les points de réseau isolants, jusqu'à la hauteur désirée, et on détache de la matrice le cliché sérigraphique structuré ainsi obtenu, caractérisé en ce qu'on ne rend conductrice la couche de Photoresist qu'à sa surface et avant le développement.

2. Procédé suivant la revendication 1, caractérisé en ce qu'on rend la surface de la couche de Photoresist conductrice après l'exposition à la lumière.

3. Procédé suivant la revendication 1, caractérisé en ce qu'on rend la surface de la couche de Photoresist conductrice par application de particules conductrices.

4. Procédé suivant la revendication 3, caractérisé en ce qu'on utilise, comme particules conductrices, de la poudre de graphite.

5. Procédé suivant la revendication 1, caractérisé en ce qu'on utilise une couche de Photoresist devenant soluble par exposition à la lumière.

6. Procédé suivant la revendication 1, caractérisé en ce qu'on utilise une matrice cylindrique.

7. Procédé suivant la revendication 1, caractérisé en ce qu'on utilise une matrice avec des cavités ou perforations, disposées en forme de réseau, qui sont remplies de matière non conductrice.

8. Procédé suivant la revendication 1, caractérisé en ce qu'on utilise une matrice avec une surface plane, sur laquelle sont placés des points de réseau en matière non conductrice.

9. Procédé suivant la revendication 1, caractérisé en ce qu'on produit le cliché sérigraphique par dépôt galvanique de nickel.

FIG.1

FIG.2

FIG.3

FIG.4

FIG.5

FIG.6

FIG.7

FIG.8

FIG.9

FIG.10

FIG.11

FIG.12

FIG.13

FIG.14